# EUROPÄISCHE PATENTSCHRIFT

(11) **EP 1 965 626 B1**
(45) Veröffentlichungstag und Bekanntmachung des Hinweises auf die Patenterteilung: **06.01.2016**
(21) Anmeldenummer: 08102087.7
(22) Anmeldetag: 27.02.2008
(51) Int. Cl.: H05K 7/14

(54) **Verschlusselement**
Latch element
Elément de verrouillage

(30) Priorität: 01.03.2007 DE 102007010042
(43) Veröffentlichungstag der Anmeldung: 03.09.2008
(73) Patentinhaber: Fujitsu Technology Solutions Intellectual Property GmbH, 80807 München (DE)
(72) Erfinder: Kieneke, Rainer, 33104 Paderborn (DE)
(74) Vertreter: Epping - Hermann - Fischer

(56) Entgegenhaltungen:
- WO-A1-2004/000078
- DE-A1-102004 020 310
- DE-C1- 19 507 437
- DE-U1-202006 014 358

## Beschreibung

Die Erfindung betrifft ein Verschlusselement für die Montage eines Varioträgers an vertikalen Trägerprofilen eines Racks, wobei die vertikalen Trägerprofile des Racks Öffnungen in einem standardisierten Raster aufweisen und der Varioträger über die Öffnungen an den vertikalen Trägerprofilen festlegbar ist.

Die Öffnungen in den vertikalen Trägerprofilen weisen in Europa quadratische Öffnungen mit einem Maß von 9 x 9 mm beziehungsweise 9,5 x 9,5 mm auf. In den USA sind die Öffnungen ebenfalls standardisiert, wobei hier ein Rundlochraster verwendet wird. Bisher werden die Trägersysteme beziehungsweise die Varioträger manuell über Schrauben mit den vertikalen Trägerprofilen verschraubt. Um die Montage zu vereinfachen, ist es wünschenswert, die Varioträger auch schraubenlos an den vertikalen Trägerprofilen der Racks festlegen zu können.

Aus der US 6,659,557 B2 ist ein System bekannt, bei dem an dem Varioträger ein Winkel mit nach innen weisenden Vorsprüngen angeschraubt ist, welcher von außen in die Öffnungen der vertikalen Trägerprofile gesteckt werden kann. Um ein Herausrutschen aus den Öffnungen zu verhindern, wird von innen ein Anschlag in Position gebracht und mit einer Schraube fixiert, sodass ein Herausrutschen der Fortsätze aus den Öffnungen nach außen verhindert wird.

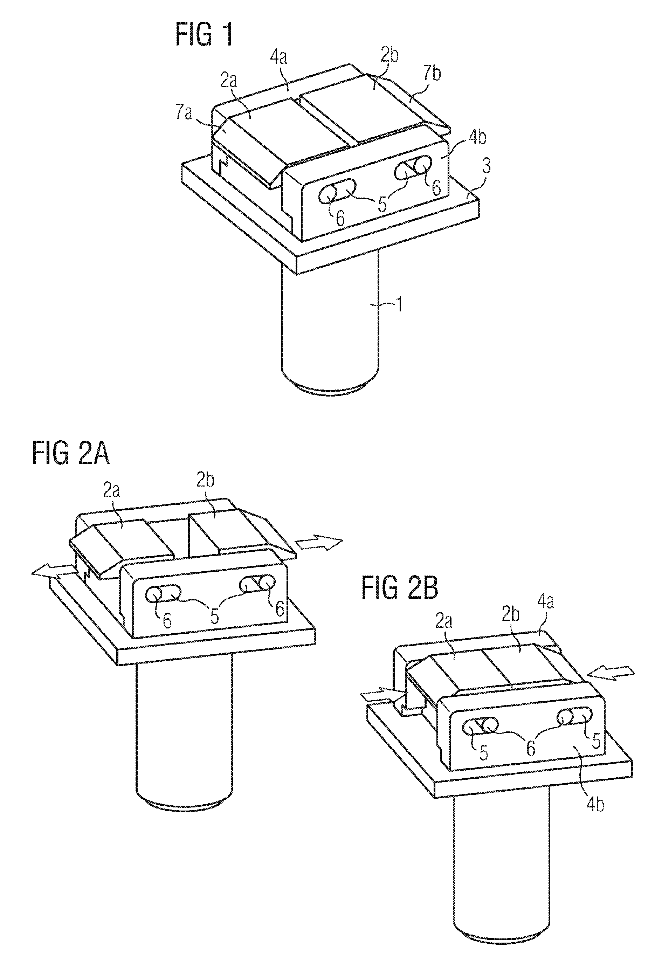

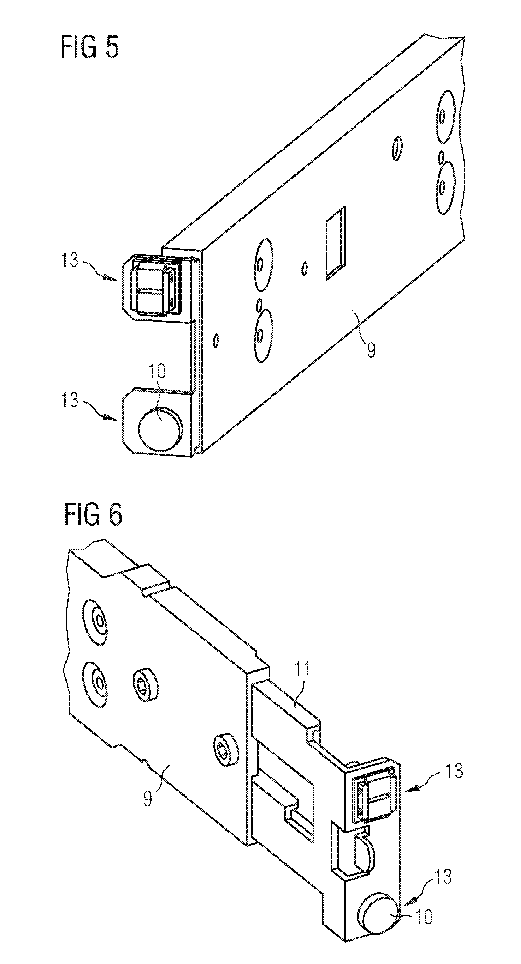

Die US 6,230,903 B1 offenbart eine alternative Lösung für eine schraubenlose Montage eines Varioträgers. Gemäß der Ausführungsform nach Figur 2 werden an einer Teleskopschiene zwei Schienen angeschraubt, welche ebenfalls endseitig nach innen vorspringende Fortsätze aufweisen und in die Öffnungen der vertikalen Trägerprofile von außen eingreifen können. Um ein Herausrutschen der Fortsätze aus den Öffnungen der vertikalen Trägerprofile zu vermeiden, werden die Schienen an einem durchgehend starren Teil der Teleskopschiene fixiert. Das Ausführungsbeispiel gemäß Figur 5 ist prinzipiell analog aufgebaut, wobei hier die Fortsätze von innen nach außen weisen, sodass die Fortsätze auch von innen nach außen durch die Öffnungen in die vertikalen Trägerprofilen zur Festlegung der Teleskopschiene gesteckt werden.

Nachteilig an diesen beiden Lösungen ist immer noch die relativ aufwändige Montage, da immer im eingesteckten Zustand der Vorsprünge in die Öffnungen bei der US 6,659,577 ein Anschlag angeschraubt werden muss und bei der US 6,230,903 die Schienen an durchgehenden Teile der Teleskopschiene befestigt werden müssen. Dies bedeutet, dass bei dieser Verschraubung die Gefahr besteht, dass die Vorsprünge wieder leicht aus den Öffnungen rutschen beziehungsweise man bei der Montage sehr darauf bedacht sein muss, dass auch bei leicht angezogenen Schrauben noch mal geprüft wird, dass die Vorsprünge komplett in die Öffnungen eingreifen und erst danach die Verschraubung festgezogen wird.

Ferner ist aus der WO 2004/000078 A1 ein Verschlusselement für Teleskopschienen bekannt, das mittels Schraubens an einer Trageschiene befestigt ist und durch einen beweglichen und einen festen Haken in den Öffnungen des vertikalen Trägerprofils mit dem Trägerprofil verbunden ist. Der bewegliche Haken kann durch Betätigung eines Hebels zwischen zwei Stellungen wechseln. In einer ersten Stellung können beide Haken durch die Öffnungen des vertikalen Trägerprofils geführt werden. In einer zweiten Stellung sind beide Haken in den Öffnungen des vertikalen Trägerprofils fest eingehakt und somit ist das Verschlusselement an dem vertikalen Trägerprofil befestigt. Ein großer Nachteil dieser Lösung ist, dass die Montage des Verschlusselements nicht werkzeuglos erfolgen kann.

Aus der DE 20 2006 014 358 U1 ist eine Gleitführung für ein Metallgestell bekannt, die von der Außenseite des vertikalen Trägerprofils montiert wird. Die Gleitführung weist eine Führung und ein Befestigungsteil mit zwei gefederten Hängeelementen auf. Die Führung weist eine Stirnplatte mit zwei Öffnungen auf, durch die die zwei Hängeelemente von Außen geführt sind und mittels des Befestigungsteils an der Stirnplatte befestigt sind. Im montierten Zustand sind die zwei Hängeelemente durch die Öffnungen des vertikalen Trägerprofils geführt und mittels einem Klemm- und Federelement auf der Führung in dieser Position fixiert. Die Stirnplatte weist zusätzlich einen Anschlag für das Klemmelement auf, der die Führung gegen seitliche Bewegungen stabilisiert. Nachteilig an dieser Lösung ist nicht nur der komplizierte Aufbau, sondern die komplizierte Montage und Demontage. Um die Gleitführung auf einem vertikalen Trägerprofil zu montieren, musste erstens das Klemmelement ungefähr senkrecht zur Führung hin gedrückt werden, zweitens die Hängeelemente durch die Öffnungen des vertikalen Trägerprofils durchgeführt werden und drittens entgegen der Kraft der Hängeelementen-Feder die Führung gezogen oder das Befestigungsteil gedrückt werden, bis das gefederte Klemmelement zurückspringt.

Des Weiteren ist aus der DE 10 2004 020 310 A1 ein Haltestück zum Befestigen von Montageschienen an Rahmenprofilen eines Schaltschranks bekannt. Das Haltestück ist blockartig geformt und weist an jedem Ende jeweils eine Rastfeder und einen Passabsatz auf, die so angeordnet sind, dass beim Einstecken des Haltestückes in eine Öffnung des Rahmenprofils die Rastfedern zusammengedrückt werden und sich erst wieder entspannen, wenn der Passabsatz am Rahmenprofil anliegt. Seitlich weist das Haltestück eine Innenaufnahme auf, in die die Montageschiene eingesteckt wird.

Aus der DE 195 07 437 C1 ist ein Anschlussteil bekannt, das in der Stirnseite von einer Montageschiene mit U-förmigen Querschnitt eingesetzt wird. Das Anschlussteil weist zwei Haken auf, die beim eingesetzten Anschlussteil seitlich aus der offenen Seite der Montageschiene herausragen. Durch eine Schraube wird der Winkel der Haken geändert, sodass sie zuerst schräg durch einen Spalt in einem Trägerprofil mit einem entsprechenden Querschnitt durchgeführt werden und dann ungefähr senkrecht zur Montageschiene das Trägerprofil durch den Spalt hintergreifen.

Nachteilig an den beiden Lösungen ist, dass sie nur für die speziell dafür konstruierten Tragschienen beziehungsweise Trägerprofile anwendbar sind. Bei der DE 10 2004 020 310 A1 muss der Querschnitt der Montageschiene zum Querschnitt der Innenaufnahme des Haltestücks passen, und bei der DE 195 07 437 C1 müssen der Querschnitt des Trägerprofils, der Querschnitt der Montageschiene und das Anschlussteil zusammen passen. Zusätzlich kann die Montage am Trägerprofil nach der DE 195 07 437 C1 nicht ohne Werkzeuge erfolgen.

Der Erfindung liegt die Aufgabe zugrunde, ein Verschlusselement für die Montage eines Varioträgers an vertikalen Trägerprofilen eines Racks aufzuzeigen, welches eine leichtere Montage des Varioträgers erlaubt.

Diese Aufgabe wird erfindungsgemäß dadurch gelöst, dass das Verschlusselement stirnseitig am Varioträger festlegbar ist und eine Rasteinrichtung aufweist, welche mit zumindest einer Feder beaufschlagt ist, zumindest eine Einführschräge an der Aussenseite aufweist, die beim Einführen der Rasteinrichtung in eine Öffnung des vertikalen Trägerprofils ein Verschieben der Rasteinrichtung in eine Stellung bewirkt, in der die Rasteinrichtung durch die Öffnung geschoben werden kann, und beim Einschieben in eine der Öffnungen an den vertikalen Trägerprofilen automatisch verrastet.

Durch das automatische Verrasten der Rasteinrichtung beim Einschieben in eine der Öffnungen an den vertikalen Trägerprofilen wird erzielt, dass der Varioträger über den Rastbeziehungsweise Schnappmechanismus einfach von einer Person am vertikalen Trägeprofil festgelegt werden kann.

Die Varioträger sind vorzugsweise in ihrer Länge verstellbar, sodass die Person, welche den Varioträger montiert, lediglich erst auf der einen Seite den Varioträger über die Schnappverbindung in den Öffnungen des vertikalen Trägerprofils festlegt und danach auf der gegenüberliegenden Seite das Verschlusselement in die Öffnung des vertikalen Trägerprofils einsteckt. Die Montage des Varioträgers ist somit extrem einfach und kann schrauben- und werkzeuglos erfolgen.

Vorzugsweise weist der Varioträger stirnseitig zwei Gewindebohrungen auf, durch welche er bisher über M5-Schrauben an den vertikalen Trägerprofilen des Racks festgelegt wurde. Für die erfindungsgemäße Wirkung ist es ausreichend, wenn pro Seite jeweils ein Verschlusselement an einem Varioträger vorgesehen ist und unterhalb beziehungsweise darüber in die Gewindebohrung eine Schraube beziehungsweise ein Bolzen eingeschraubt ist. Die Schraube bzw. der Bolzen wird ebenso durch die Öffnung gesteckt und dient so mit zur Kraftübertragung auf die vertikalen Trägerprofile, ohne jedoch den Varioträger an den vertikalen Trägerprofilen festzulegen.

Das Verschlusselement weist vorzugsweise einen Gewindebolzen auf, welcher in die Gewindebohrungen des Varioträgers eingeschraubt werden kann, über welche bisher die Varioträger mit den vertikalen Trägerprofilen des Racks verschraubt wurden.

Diese kompatible Festlegung der Verschlusselemente an den Gewindebohrungen am Varioträger hat den Vorteil, dass bei der Montage des Varioträgers an einem Rack, welches Öffnungen aufweist, die in ihrer Norm oder in ihren Abmessungen nicht mit der Geometrie des Verschlusselementes zusammenpassen, der Varioträger ebenfalls wie bisher noch über Schrauben montiert werden kann. Zum Beispiel wenn das Verschlusselement auf die europäische Norm, das heißt auf ein quadratisches Lochraster abgestimmt ist, ist es möglich, den Varioträger an einem Rack mit runden Öffnungen nach der US-Norm noch mittels Schrauben zu befestigen.

Gemäß einer bevorzugten Ausführungsform weist das Verschlusselement ein federbeaufschlagtes Rastelement auf, welche beim Einschieben in die Öffnung am vertikalen Trägerprofil automatisch zurückfedert und in ihrer Endposition wieder ausfedert und das Trägerprofil hintergreift.

Durch diesen Rastmechanismus ist eine einfache und unproblematische Montage gewährleistet. Gemäß einer bevorzugten Ausführungsform werden zwei gegenüberliegende Rastelemente verwendet, welche ebenfalls beide automatisch beim Einschieben des Verschlusselementes in eine Öffnung eines Trägerprofils automatisch einfedern. Zum Einfedern ist an der Außenseite der Rastelemente eine Einführschräge vorgesehen, welche diese automatisch beim Einführen in eine Öffnung des Trägerprofils nach innen drückt.

Um eine definierte Montageposition zu erzielen, ist am Verschlusselement auch ein flächiger Anschlag ausgebildet, welcher im montierten Zustand seitlich der Öffnung am Trägerprofil anliegt.

Weitere vorteilhafte Ausgestaltungen sind in den Unteransprüchen sowie auch in der nachfolgenden Figurenbeschreibung offenbart.

Anhand eines in den Zeichnungen dargestellten Ausführungsbeispieles wird die Erfindung nun näher erläutert.

In den Zeichnungen zeigen:
- Figur 1: ein Verschlusselement in Schrägansicht,
- Figur 2A: eine weitere Schrägansicht des Verschlusselements mit den Rastelementen in Einraststellung,
- Figur 2B: die Ansicht gemäß Figur 2A mit den Rastelementen in nicht verrasteter Stellung,
- Figur 3: eine Außenansicht auf ein Trägerprofil mit eingerastetem Verschlusselement,
- Figur 4: eine Schrägansicht eines Varioträgers montiert an zwei vertikalen Trägerprofilen eines Racks,
- Figur 5: eine Schrägansicht auf die Stirnseite eines Varioträgerprofils,
- Figur 6: eine weitere Schrägansicht auf die rückseitige Stirnseite des Varioträgerprofils,
- Figur 7: die Ansicht eines montierten Varioträgers an einem vertikalen Trägerprofil von vorne innen,
- Figur 8: die Ansicht eines montierten Varioträgers an einem vertikalen Trägerprofil von hinten außen, und
- Figur 9: in Großansicht die Stirnseite eines Varioträgers in Explosionsdarstellung mit den alternativen Befestigungsarten über eine Schraube und das erfindungsgemäße Verschlusselement.

Figur 1 zeigt in Schrägansicht ein Verschlusselement zur Befestigung eines Varioträgers an vertikalen Trägerprofilen eines Serverracks.

Das Verschlusselement weist einen Gewindebolzen 1 auf, über welchen es am Varioträger festgelegt wird.

Für die Verbindung mit den vertikalen Trägerprofilen sind stirnseitig zwei Rastelemente 2a und 2b ausgeführt, welche durch eine in der Zeichnung nicht erkennbare Feder in die in Figur 1 dargestellte Stellung gedrückt werden.

An den Gewindebolzen 1 schließt sich ein flächiger Anschlag 3 an, von welchem sich zwei Stege 4a und 4b auf der gegenüberliegenden Seite des Gewindebolzens 1 erstrecken, wobei zwischen den beiden Stegen 4a und 4b die Rastelemente 2a und 2b aufgenommen sind. Für die Aufnahme der Rastelemente 2a und 2b sind in den Stegen jeweils Langlöcher 5 ausgebildet, in welchen entsprechende Achsen 6 der Rastelemente 2a und 2b aufgenommen sind. Die Rastelemente 2a und 2b weisen an ihrer Außenseite jeweils in dem Bereich, in dem sie seitlich über die Stege 4a und 4b überstehen, Einführschrägen 7a beziehungsweise 7b auf, welche beim Einschieben des Verschlusselements in eines der Öffnungen in den vertikalen Trägerprofilen bewirken, dass die Rastelemente 2a beziehungsweise 2b entgegen der Kraft der Feder so weit nach innen gepresst werden, dass die äußeren Kanten bündig mit den seitlichen Stirnseiten der Stege 4a beziehungsweise 4b verlaufen.

In Figur 2A ist nochmals das Verschlusselement in Schrägansicht zu sehen, wobei hier die Rastelemente 2a beziehungsweise 2b wie in Figur 1 dargestellt in Einraststellung sich befinden. Die Achsen befinden sich in dieser Stellung an den äußeren Enden der Langlöcher 5.

Figur 2B hingegen zeigt das Verschlusselement in der gleichen Schrägansicht wie in Figur 2A, wobei hier die beiden Rastelemente 2a und 2b in der nicht verrasteten Stellung gezeigt sind. Die beiden Achsen 6 sind hierbei an den inneren Enden der Langlöcher 5 angeordnet und die äußeren Kanten der Rastelemente 2a beziehungsweise 2b stehen nicht seitlich über die Stege 4a beziehungsweise 4b über.

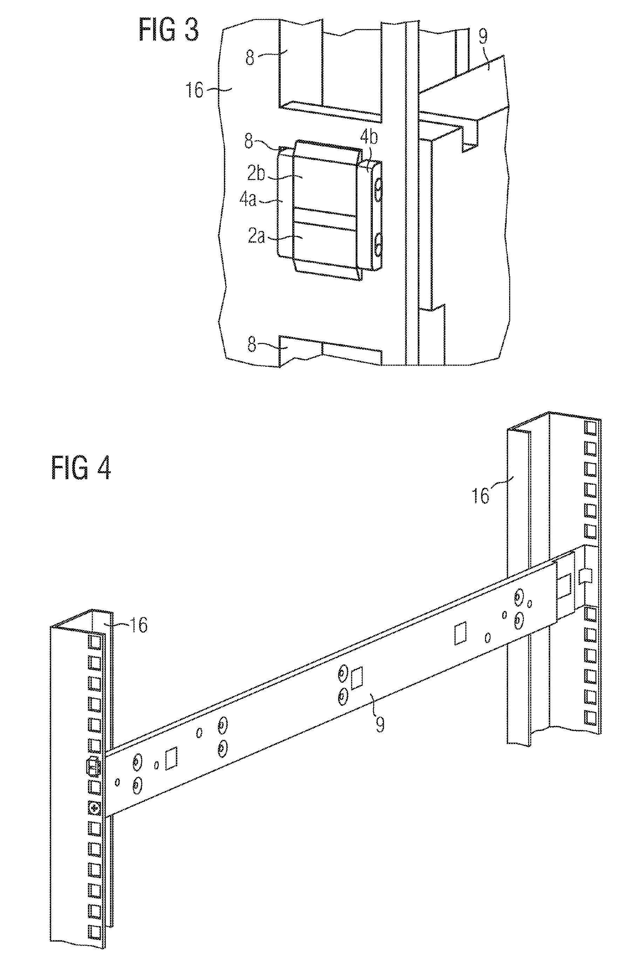

Figur 3 zeigt in einem Ausschnitt ein vertikales Trägerprofil 16 eines Serverracks, in welchem standardisierte quadratische Öffnungen 8 in einem vorgegebenen Raster ausgebildet sind. An das vertikale Trägerprofil 16 ist ein Varioträger 9 über ein in den Figuren 1 beziehungsweise 2A und 2B dargestelltes Verschlusselement montiert. Die Stege 4a und 4b sind so dimensioniert, dass sie sowohl vertikal auch wie horizontal nur mit geringfügigem Spiel durch die Öffnungen 8 hindurch gesteckt werden können. Die Rastelemente 2a beziehungsweise 2b sind im verrasteten Zustand dargestellt. Die im Inneren der Rasteinrichtung verborgene Feder drückt die Rastelemente 2a, 2b nach außen, sodass die stirnseitigen Enden der Rastelemente 2a und 2b das vertikale Trägerprofil 7 seitlich der Öffnung 8 umgreifen und es somit unmöglich ist, das Rastelement und somit das Verschlusselement aus der Öffnung 8 herauszuziehen.

Zum Lösen der Rastelemente 2a und 2b müssen diese mit den Fingern zusammengepresst werden, wodurch sich das Verschlusselement aus der Öffnung 8 ziehen lässt.

In Figur 4 ist der gesamte Varioträger 9 von der Innenseite dargestellt, wie er an zwei vertikale Trägerprofile 16 eines Serverracks montiert ist. Der Varioträger 9 ist in seiner Länge verstellbar, sodass zuerst die Montage auf der einen Seite an einem der vertikalen Trägerprofile 16 erfolgt und danach der Varioträger ausgezogen wird und auf der anderen Seite über das Verschlusselement in eine der Öffnungen 8 am gegenüberliegenden vertikalen Trägerprofil 16 gesteckt wird.

Figur 5 zeigt eine Schrägansicht eines Endes des Varioträgers 9. Der Varioträger 9 weist stirnseitig zwei Gewindebohrungen 13 auf, wobei gemäß Figur 5 in der oberen Gewindebohrung 13 ein erfindungsgemäßes Verschlusselement eingesetzt ist und in der unteren Gewindebohrung eine Zentrierschraube 10, welche dazu dient, dass sich der Varioträger 9 in der montierten Stellung nicht drehen kann und zum anderen auch damit die vertikalen Kräfte über die Zentrierschraube 10 auf das vertikale Trägerprofil 7 übertragen werden.

Figur 6 zeigt das andere Ende des Varioträgers 9, wobei dieses Ende einen ausziehbaren Teil 11 aufweist, welcher ebenso stirnseitig mit zwei Gewindebohrungen 13 versehen ist, in welche die untere ebenso wie auf der Vorderseite eine Zentrierschraube 10 und in die obere Gewindebohrung 13 das erfindungsgemäße Verschlusselement eingeschraubt ist.

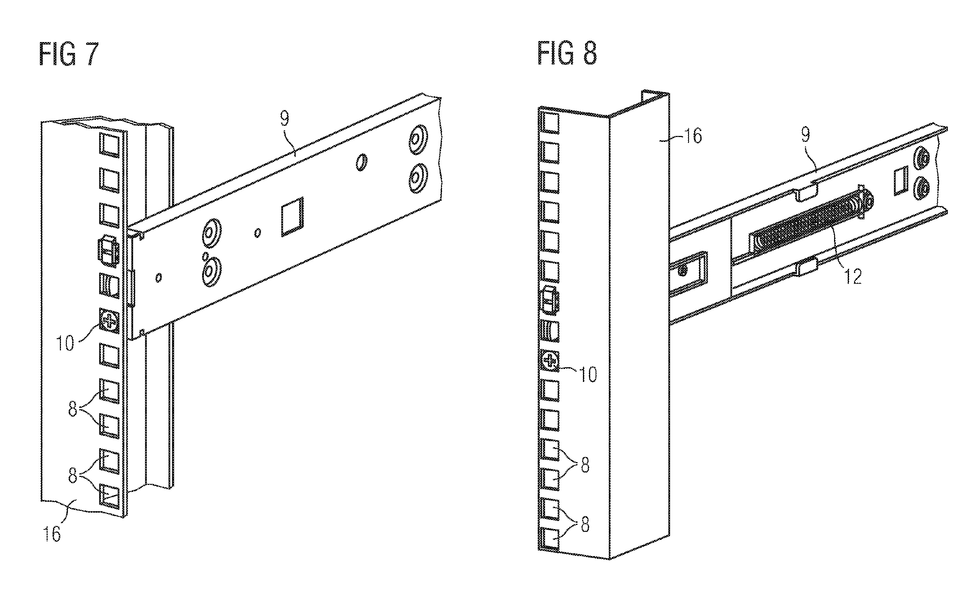

Die Figuren 7 und 8 zeigen den Varioträger 9, wie er in Figur 7 an der vorderen Seite an das vertikale Trägerprofil 16 über die Öffnungen 8 montiert ist und in Figur 8, wie er an der hinteren Seite an das vertikale Trägerprofil über die Öffnungen 8 montiert ist. Sowohl an der Vorderseite wie auch an der Hinterseite wurde für die obere Befestigung das erfindungsgemäße Verschlusselement und für die untere Gewindebohrung eine Zentrierschraube 10 verwendet.

Figur 8 zeigt den Varioträger 9 in der Ansicht von außen, wobei hier zu sehen ist, dass dieser nicht nur in der Länge verschiebbar ist, sondern die Längenverschiebung auch noch über eine Feder 12 beaufschlagt ist.

Der Varioträger 9 dient zur Festlegung von Teleskopschienen, an welche wiederum ausziehbare Einschübe für das Serverrack montiert werden.

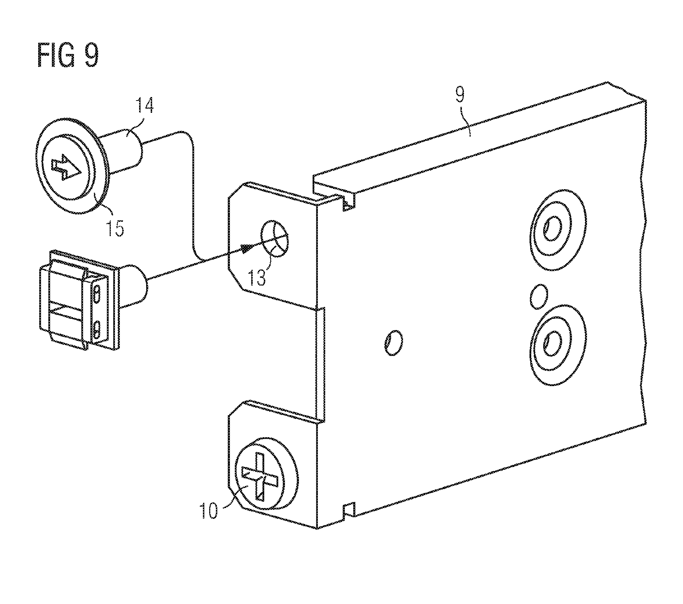

Figur 9 zeigt in Schrägansicht eine Stirnseite des Varioträgers 9, mit den beiden Gewindebohrungen 13, wobei in die untere Gewindebohrung wiederum die Zentrierschraube 10 eingesetzt ist. An der oberen Gewindebohrung kann alternativ je nachdem ob eine Verschraubung gewünscht ist, eine Schraube 14 mit einer Zentrierscheibe 15 verwendet werden oder das erfindungsgemäße Verschlusselement.

Die Erfindung ist nicht auf das dargestellte Ausführungsbeispiel beschränkt, so sind alle Verschlusselemente umfasst, welche es ermöglichen, einen Varioträger über eine Schnappbeziehungsweise Rastverbindung an den Trägerprofilen eines Racks festzulegen.

### Bezugszeichenliste

- 1: Gewindebolzen
- 2a, 2b: Rastelemente
- 3: Anschlag
- 4a, 4b: Stege
- 5: Langlöcher
- 6: Achsen
- 7a, 7b: Einführschrägen
- 8: Öffnungen
- 9: Varioträger
- 10: Zentrierschraube
- 11: ausziehbarer Teil
- 12: Feder
- 13: Gewindebolzen
- 14: Schraube
- 15: Feder
- 16: Trägerprofil

## Patentansprüche

1. Verschlusselement für die Montage eines Varioträgers (9) an vertikalen Trägerprofilen (16) eines Racks, wobei die vertikalen Trägerprofile (16) des Racks Öffnungen (8) in einem standardisierten Raster aufweisen und der Varioträger (9) über die Öffnungen (8) an den vertikalen Trägerprofilen (16) festlegbar ist,
wobei
das Verschlusselement stirnseitig am Varioträger (9) festlegbar ist und zumindest ein Rastelement (2a, 2b) aufweist, **dadurch gekennzeichnet, dass** das Rastelement
- mit zumindest einer Feder beaufschlagt ist,
- zumindest eine Einführschräge an der Aussenseite aufweist, die beim Einführen des Rastelementes (2a, 2b) in eine Öffnung des vertikalen Trägerprofils ein Verschieben des Rastelementes (2a, 2b) in eine Stellung bewirkt, in der das Rastelement (2a, 2b) durch die Öffnung geschoben werden kann, und
- beim Einschieben in eine der Öffnungen (8) an den vertikalen Trägerprofilen (16) automatisch verrastet.

2. Verschlusselement nach Anspruch 1,
**dadurch gekennzeichnet, dass**
der Varioträger (9) stirnseitig zwei Gewindebohrungen (13) aufweist und das Verschlusselement einen Gewindebolzen (1) aufweist und über den Gewindebolzen (1) in den Gewindebohrungen (13) des Varioträgers (9) festlegbar ist.

3. Verschlusselement nach Anspruch 1 oder 2,
**dadurch gekennzeichnet, dass**
das Rastelement (2a, 2b) vertikal zur Einschubrichtung in die Öffnung des vertikalen Trägerprofils (16) verschiebbar ist.

4. Verschlusselement nach einem der Ansprüche 1 bis 3,
**dadurch gekennzeichnet, dass**
zwischen dem Rastelement (2a, 2b) und dem Gewindebolzen (1) ein flächiger Anschlag (3) vorgesehen ist, der im montierten Zustand des Verschlusselementes am Umfang der Öffnung (8) des vertikalen Trägerprofils (7) anliegt.

5. Verschlusselement nach Anspruch 4,
**dadurch gekennzeichnet, dass**
von dem flächigen Anschlag (3) zwei Stege (4a, 4b) abstehen und das zumindest eine Rastelement (2a, 2b) horizontal verschiebbar zwischen den Stegen (4a, 4b) aufgenommen ist.

6. Verschlusselement nach Anspruch 5,
**dadurch gekennzeichnet, dass**
die Länge der Stege (4a, 4b) und der Abstand der Außenseiten der Stege (4a, 4b) so auf die Öffnungen (8) im vertikalen Trägerprofil (7) so abgestimmt sind, dass die Stege (4a, 4b) sowohl horizontal als auch vertikal mit nur geringem Spiel in den Öffnungen (8) aufgenommen werden können.

7. Verschlusselement nach einem der Ansprüche 1 bis 6,
**dadurch gekennzeichnet, dass**
pro Verschlusselement zwei Rastelemente (2a, 2b) vorgesehen sind.

8. Rack mit zumindest vier vertikalen Trägerprofilen (16), die mit Öffnungen (8) in einem standardisierten Raster versehen sind und wobei zwischen zwei vertikalen Trägerprofilen (16) so genannte Varioträger (9) montiert sind, die wiederum zur Festlegung von Teleskopschienen dienen,
**dadurch gekennzeichnet, dass**
ein Varioträger (9) über zumindest zwei Verschlusselemente nach einem der Ansprüche 1 bis 7 an den vertikalen Trägerprofilen (16) festgelegt ist.

## Claims

1. Closure element for mounting a variable support (9) on vertical support profiles (16) of a rack, wherein the vertical support profiles (16) of the rack have openings (8) in a standardized grid and the variable support (9) is fixable to the vertical support profiles (16) by way of the openings (8), wherein
the closure element is fixable to the variable support (9) at the end side and has at least one latch element (2a, 2b), **characterized in that** the latch element
- is impingeable by at least one spring,
- on the outer side has at least one insertion ramp which during introduction of the latch element (2a, 2b) into an opening of the vertical support profile causes a displacement of the latch element (2a, 2b) to a position in which the latch element (2a, 2b) can be pushed through the opening, and
- during sliding into one of the openings (8) automatically latches to the vertical support profiles (16).

2. Closure element according to Claim 1, **characterized in that**
the variable support (9) at the end side has two threaded bores (13), and the closure element has a threaded bolt (1) and by way of the threaded bolt (1) is fixable in the threaded bores (13) of the variable support (9).

3. Closure element according to Claim 1 or 2, **characterized in that**
the latch element (2a, 2b) is displaceable into the opening of the vertical support profile (16) in a perpendicular manner to the insertion direction.

4. Closure element according to one of Claims 1 to 3, **characterized in that**
a planar stop (3) which in the mounted state of the closure element bears on the circumference of the opening (8) of the vertical support profile (7) is provided between the latch element (2a, 2b) and the threaded bolt (1).

5. Closure element according to Claim 4, **characterized in that**
two webs (4a, 4b) project from the planar stop (3), and the at least one latch element (2a, 2b) is received between the webs (4a, 4b) so as to be horizontally displaceable.

6. Closure element according to Claim 5, **characterized in that**
the length of the webs (4a, 4b) and the spacing of the outer sides of the webs (4a, 4b) are adapted to the openings (8) in the vertical support profile (7) such that the webs (4a, 4b) may be received in the openings (8) with only minor play both in the horizontal as well as in the vertical direction.

7. Closure element according to one of Claims 1 to 6, **characterized in that**
two latch elements (2a, 2b) are provided per closure element.

8. Rack having at least four vertical support profiles (16) which are provided with openings (8) in a standardized grid, and wherein so-called variable supports (9) are mounted between two vertical support profiles (16), which variable supports (9) in turn serve for fixing telescopic rails,
**characterized in that**
a variable support (9) is fixed to the vertical support profiles (16) by way of at least two closure elements according to one of Claims 1 to 7.

## Revendications

1. Élément de fermeture pour le montage d'un support variable (9) sur des profilés porteurs verticaux (16) d'un rack, sachant que les profilés porteurs verticaux (16) du rack présentent des ouvertures (8) dans une trame normalisée et le support variable (9) peut être fixé sur les profilés porteurs verticaux (16) par le biais des ouvertures (8),
dans lequel
l'élément de fermeture peut être fixé face avant sur le support variable (9) et présente au moins un élément d'encliquetage (2a, 2b), **caractérisé en ce que** l'élément d'encliquetage
- est sollicité par au moins un ressort,
- présente au moins un biseau d'insertion sur le côté extérieur, qui, lorsque l'élément d'encliquetage (2a, 2b) est introduit dans une ouverture du profilé porteur vertical, effectue un déplacement de l'élément d'encliquetage (2a, 2b) dans une position dans laquelle l'élément d'encliquetage (2a, 2b) peut être poussé à travers l'ouverture, et
- s'enclique automatiquement dans une des ouvertures (8) sur les profilés porteurs verticaux (16).

2. Élément de fermeture selon la revendication 1,
**caractérisé en ce que**
le support variable (9) présente deux filetages (13) à l'avant et l'élément de fermeture présente un boulon fileté (1) et peut être fixé dans les filetages (13) du support variable (9) par le biais du boulon fileté (1).

3. Élément de fermeture selon la revendication 1 ou 2,
**caractérisé en ce que**
l'élément d'encliquetage (2a, 2b) peut être déplacé dans l'ouverture du profilé porteur vertical (16) verticalement au sens d'insertion.

4. Élément de fermeture selon l'une des revendications 1 à 3,
**caractérisé en ce**
**qu'**une butée plane (3) est prévue entre l'élément d'encliquetage (2a, 2b) et le boulon fileté (1), qui repose sur le pourtour de l'ouverture (8) du profilé porteur vertical (7) lorsque l'élément de fermeture est monté.

5. Élément de fermeture selon la revendication 4,
**caractérisé en ce que**
deux traverses (4a, 4b) partent de la butée plane (3) et **en ce que** l'au moins un élément d'encliquetage (2a, 2b) est reçu entre les traverses (4a, 4b) en pouvant être poussé horizontalement.

6. Élément de fermeture selon la revendication 5,
**caractérisé en ce que**
la longueur des traverses (4a, 4b) et l'écart des côtés extérieurs des traverses (4a, 4b) sont ainsi déterminés par rapport aux ouvertures (8) dans le profilé porteur vertical (7) et **en ce que** les traverses (4a, 4b) peuvent être reçues tant horizontalement que verticalement dans les ouvertures (8) avec seulement un faible jeu.

7. Élément de fermeture selon l'une des revendications 1 à 6,
**caractérisé en ce que**
deux éléments d'encliquetage (2a, 2b) sont prévus par élément de fermeture.

8. Rack comprenant au moins quatre profilés porteurs verticaux (16) qui sont dotés d'ouvertures (8) dans une trame normalisée et dans lequel, entre deux profilés porteurs verticaux (16), des dits supports variables (9) sont montés qui servent à leur tour à fixer des rails télescopiques,
**caractérisé en ce**
**qu'**un support variable (9) est fixé sur les profilés porteurs verticaux (16) par au moins deux éléments de fermeture selon l'une des revendications 1 à 7.
